Europäisches Patentamt

European Patent Office

Office européen des brevets

(11) Publication number: **0 434 398 A2**

## EUROPEAN PATENT APPLICATION

(21) Application number: 90313928.5

(51) Int. Cl.5: **B41M 5/38**, G03F 7/00

(22) Date of filing: 19.12.90

(30) Priority: 19.12.89 JP 329318/89
10.07.90 JP 184957/90

(43) Date of publication of application:
26.06.91 Bulletin 91/26

(84) Designated Contracting States:
DE FR GB

(71) Applicant: SUMITOMO RUBBER INDUSTRIES
LIMITED
1-1 Tsutsuicho 1-chome Chuo-ku
Kobe-shi Hyogo-ken(JP)

(72) Inventor: Tominaga, Ichiro
31-7, Aobadai, Kita-ku
Kobe-shi, Hyogo-ken(JP)
Inventor: Sasaki, Takashi
Sumitomogomukoburyo, 1-1-23,
Hinokuchi-cho
Nishinomiya-shi, Hyogo-ken(JP)
Inventor: Nakamura, Yoshinobu
Sumiyoshi-ryo, 4-6-10, Konan-cho
Higashinada-ku, Kobe-shi, Hyogo-ken(JP)

(74) Representative: Allard, Susan Joyce et al
BOULT, WADE & TENNANT, 27 Furnival
Street
London EC4A 1PQ(GB)

(54) Heat transfer film for marking articles and marking process using the same.

(57) A new marking technique is disclosed which is suitable for marking a variety of images on a small number of articles. The technique employs a heat transfer film comprising (a) a substrate, (b) a heat transferable marking layer formed on areas at least covering the image areas of the substrate, and (c) a masking layer having spaces corresponding to the images. The present invention also provides a marking process using the heat transfer film.

EP 0 434 398 A2

# HEAT TRANSFER FILM FOR MARKING ARTICLES AND MARKING PROCESS USING THE SAME

The present invention relates to a heat transfer film for marking on articles (e.g. golf balls, tennis balls) and a marking process using the same.

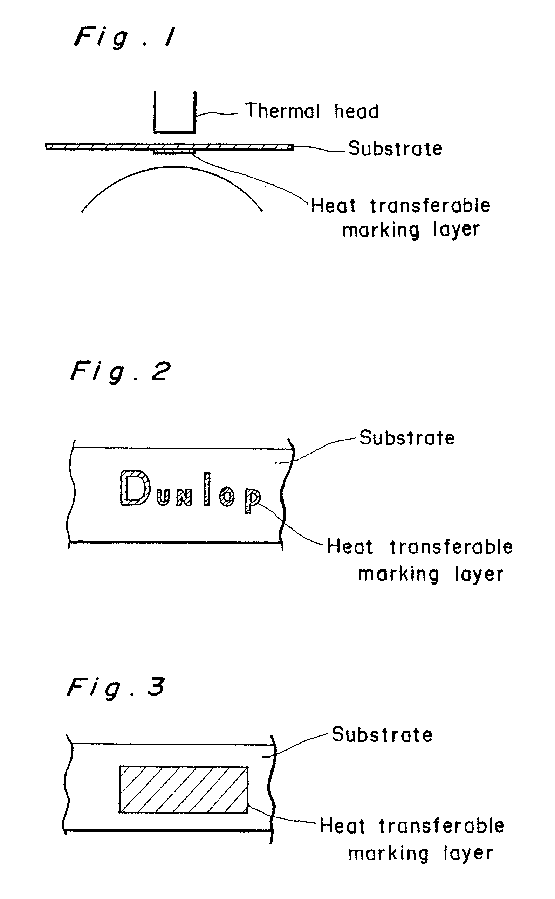

Hitherto, a heat transfer process has been applied for marking names or other images on tennis balls, golf balls and the like. In this process, a heat transfer film, consisting of heat transferable images formed on a substrate film, is placed between a thermal head and an article to be marked in such a manner that the transferable images face the article surface, as shown in Fig. 1, and then heat is applied from the opposite side by a thermal head to transfer the images on the article.

The heat transfer film is generally produced by gravure printing or screen printing by which the images to be heat-transferred are directly formed on the substrate film. In this method, the images which are to be heat-transferred should be printed on the film, as shown in Fig. 2. The gravure printing, for example, is generally carried out by steps, i.e. designing → making a block copy → making a negative → etching of the images on a gravure roll → gravure printing. This process is very suitable for marking the same images on a large number of articles, such as golf balls, but is not suitable for marking a variety of images on small amounts of articles. Once the gravure roll is etched, the roll can not be used for another image. In order to mark a variety of images, the same number of gravure rolls as the number of images must be prepared, which significantly increases production costs.

The number of people who wish to mark their names or the names of clubs to which they belong on golf balls, tennis balls, golf clubs and tennis rackets increases. It, however, is very difficult to apply the gravure printing method for this requirement because of the reasons mentioned above. Screen printing also has similar problems.

The present invention provides a new marking technique which is suitable for marking a variety of images on a small number of articles. The heat transfer film of the present invention comprises (a) a substrate, (b) a heat transferable marking layer formed on areas at least covering the image areas of the substrate, and (c) a masking layer having spaces corresponding to the images.

The present invention also provides a process for marking an image on an article using the heat transfer film, comprising contacting the article to a heat transfer film as described above by facing the article surface with the masking layer, heating said heat transfer film from the substrate side to transfer the images onto the article, and removing said heat transfer film from the article.

Fig.1 shows a schematical view of a marking apparatus using a conventional heat transfer film.

Fig.2 shows a plan view of a conventional heat transfer film.

Fig.3 shows a plan view of one embodiment of the heat transfer film of the present invention.

The substrate for the heat transfer film of the present invention is not limited in nature, for example paper, plastics and the like may be employed. The thickness and shape of the substrate also are not limited and can be varied according to the purpose of usage.

The heat transferable marking layer is generally prepared from a heat transferable ink which is known to the art. It is preferred that the heat transferable ink comprises an ethylene-vinyl acetate copolymer and a colorant. Examples of the colorants are inorganic pigments, such as carbon black, titanium oxide and iron oxide red; and organic pigments, such as lake reds and disazo dyes.

The heat transferable ink is coated on the substrate to form the heat transferable marking layer. The coating process is not limited. Preferred coating processes are hot gravure printing or screen printing. The marking layer is formed on areas which at least cover the image to be transferred. Accordingly, the marking layer can be formed either on the whole surface of the substrate or on partial portions of the substrate. It is important in the present invention that the marking layer is not faithful to the image, but is solidly coated, as shown in Fig.3.

The masking layer of the present invention has spaces corresponding to the images. The masking layer can be made by two methods. One is a method in which paper or plastics from which the spaces corresponding to the image are cut out is contacted to the heat transferable marking layer and adhered thereto. In this case the masking layer will preferably have a thickness of 0.01 to 0.60 mm, more preferably 0.05 to 0.30 mm. If the layer has a thickness of less than 0.01 mm, masking properties are deteriorated. If it has a thickness of more than 0.6 mm, the images may not be transferred sufficiently.

The other is a method in which a negative type photosensitive resin composition is formed on the marking layer and then exposed to light to form the masking layer of the present invention. The negative type photosensitive resin composition will generally contain a radically polymerizable monomer and a photopolymerization initiator. The composition may contain a photosensitizer, a viscosity modifier and the like. It is preferred that glass microparticles are formulated into the composition, because they effectively prevent the heat transferable ink from oozing out through fine cracks present in the photocured masking layer. An average particle size of the glass microparticles is not specified, but is preferably less than 250 micron. The amount of the glass microparticles will generally be within the range of 1 to 15 % by weight, preferably 1 to 6 % by weight. Amounts of more than 15 % by weight reduce optical transmission and retard photocuring time. Amounts of less than 1 % by weight often give rise to the problems of oozing out of the melted heat transferable ink. The glass microparticles may be either solid or hollow and may be formed from silicate glass, borosilicate glass and the like. Hollow glass microparticles are available from Sumitomo Three-M Co., Ltd., Nihon Silica Co., Ltd., solid ones are available from Toshiba Barotini Co., Ltd.

The negative type photosensitive resin composition may be coated on the heat transferable marking layer by any methods, for example coating, printing and the like.

The photosensitive resin layer is exposed through a negative film having negative images. In order to spoil the negative film, the photosensitive resin layer may be covered with a transparent film if necessary. Examples of the transparent films are a polyethylene film having a thickness of 0.005 to 0.05 mm. Exposing conditions, i.e. exposing time, central wave length of light, etc. are known in the art, but it is preferred in view of producibility or workability that the exposing time is less than 10 seconds and the central wave length of light is more than 350 nm. By the exposure, the exposed portion of the photosensitive resin layer is cured and the unexposed portion is not cured.

After the exposure, the negative film is removed and if necessary the uncured portion is removed by air blowing, rinsing with a solvent for the photosensitive resin, and the like. In case where the uncured portion is not removed, the uncured portion when heated is transferred onto the article surface together with the heat transferable ink. The process wherein the uncured portion is not removed is preferred in view of producibility and workability, as long as the presence of the uncured portion does not deteriorate the transferred images and the transferring process.

The heat transfer film of the present invention may be contacted with an article to be transferred and then heated from the substrate side to heat-transfer the images onto the surface of the article (e.g. tennis balls, golf balls, golf clubs, tennis rackets and the like). Heating may be carried out by for example a heat roll, a heat die and the like.

The heat transfer film of the present invention makes it possible to mark a variety of images on a small number of articles, because it is easy to change the image spaces in the masking layer. In the present invention, only one gravure roll is used for coating a marking layer, even if a variety of images is to be printed on the articles.

EXAMPLES

The present invention is illustrated by the following examples which, however, are not to be construed as limiting the present invention to their details.

Example 1

A heat transferable marking ink composition was prepared by mixing an ethylene-vinyl acetate copolymer and 5 % by weight of carbon black, and printed on a paper substrate having a width of 50 mm and a thickness of 0.05 mm by hot gravure printing to form a marking layer having a thickness of 0.6 mm. Next, K and L letters of 5 mm width were cut out of a paper sheet which had a thickness of 0.8 mm, and was adhered on the marking layer to form a heat transfer film.

The heat transfer film was contacted with a tennis ball by facing the tennis ball to the masking layer and heating from the paper substrate side by a heat die to transfer the two letters (K and L) onto the tennis ball. The transferred letters (K and L) on the ball were clear and distinct and had good durability which equalled that of the conventional heat transfer process using gravure printing.

Example 2

A marking layer was formed on a paper substrate as generally described in Example 1. On the marking layer, a photosensitive resin composition, which was prepared from dipentaerythritolsaxa penta, hexa, acrylate mixture, 8 wt % of 2,4-diethyl-thioxanetone and 8 wt % of isoamyl 4-dimethylaminobenzoate, was coated to form a photosensitive resin layer of 0.25 mm, and a high pressure process polyethylene film of 0.03 mm was covered thereon to form a photosensitive layer. Then, a negative layer having black K and L letters of 5 mm width was put on the photosensitive layer and exposed to a light source having an out put power of 10 Watt and a central wave length of 360 nm at a distance of 10 cm for 10 seconds.

Next, the negative film and polyethylene film were removed, and heat-transferred by the heat die as generally described in Example 1. The transferred letters (K and L) on the ball were clear and distinct and had good durability which equalled that of the conventional heat transfer process using gravure printing.

## Example 3

A heat transfer film was prepared as generally described in Example 2, with the exception that the photosensitive resin composition was changed to a composition which comprised a photosensitive monomer (available from Fujikura Kasei Co., Ltd. as Fuji Hard) and 10 wt % of polymethyl methacrylate (PMMA). Heat transferring was conducted as generally described in Example 2 to obtain two letters (K and L) which were clear and distinct and had good durability which equalled that of the conventional heat transfer process using gravure printing.

## Example 4

The heat transfer film obtained in Example 2 having more than 50 images was heat transferred onto 50 tennis balls as generally described in Example 2. Some of the marked tennis balls showed unexpected small points and lines other than the two letters K and L. The unexpected points and lines were considered due to oozing out of the marking ink through the cracks of the photosensitive layer when heated.

The above process was repeated with the exception that hollow glass microparticles (available from Sumitomo Three-M Co., Ltd. as Scotchlite Glass Babble S60/10000) were formulated into the photosensitive resin composition of Example 2 by changing formulating amounts to 0.05 wt %, 1 wt %, 3 wt % and 10 wt %. The heat transfer films containing 1 to 10 wt % of glass microparticles did not show such unexpected points and lines. The heat transfer film containing 0.05 wt % of particles showed such unexpected points and lines in a very small number of tennis balls.

## Claims

1. A heat transfer film for marking an image on articles comprising;
   (a) a substrate,
   (b) a heat transferable marking layer formed on areas at least covering the image areas of said substrate, and
   (c) a masking layer having spaces corresponding to the images.

2. A heat transfer film as claimed in Claim 1 wherein the substrate is prepared from paper or plastics.

3. A heat transfer film as claimed in Claim 1 or Claim 2 wherein the heat transferable marking layer is prepared from a heat transferable ink which comprises an ethylenevinyl acetate copolymer and a colorant.

4. A heat transfer film as claimed in any one of Claims 1 to 3 wherein the heat transferable marking layer is formed by gravure printing or screen printing.

5. A heat transfer film as claimed in any one of Claims 1 to 4 wherein the masking layer is prepared by a method in which paper or plastic out of which spaces corresponding to the images have been removed is contacted to the heat transferable marking layer and adhered thereto.

6. A heat transfer film as claimed in any one of Claims 1 to 4 wherein the masking layer is prepared by a method in which a negative type photosensitive resin composition is formed on the marking layer and then exposed to light to cure the exposed portion.

7. A heat transfer film as claimed in Claim 6 wherein the negative type photosensitive resin composition comprises a radically polymerizable monomer and a photopolymerization initiator.

8. A heat transfer film as claimed in Claim 6 or Claim 7 wherein the negative type photosensitive resin composition contains a photosensitizer and a viscosity modifier.

9. A heat transfer film as claimed in any one of Claims 6 to 8 wherein the negative type photosensitive resin composition contains glass microparticles.

10. A heat transfer film according to Claim 9 wherein the glass microparticles are present in an amount of 0.1 to 15 % by weight based on the total composition weight.

11. A heat transfer film as claimed in any one of Claims 6 to 10 wherein said photosensitive resin layer may be covered with a transparent film.

12. A heat transfer film as claimed in any one of Claims 6 to 11 wherein said article to be marked is selected from tennis balls, golf balls, golf clubs and tennis rackets.

13. A process for marking an image on an article comprising;
   contacting the article to a heat transfer film as defined in any one of Claims 1 to 12 by facing the article surface with the masking layer,

heating said heat transfer film from the substrate side to transfer the images onto the article, and
removing said heat transfer film from the article.

14. A process as claimed in Claim 13 wherein the heating is carried out by a heat roll or a heat die.

## Fig. 1

Thermal head

Substrate

Heat transferable
marking layer

## Fig. 2

Substrate

Dunlop

Heat transferable
marking layer

## Fig. 3

Substrate

Heat transferable
marking layer